# EUROPEAN PATENT APPLICATION

(11) **EP 1 746 656 A2**
(43) Date of publication of application: **24.01.2007**
(21) Application number: 06253648.7
(22) Date of filing: 12.07.2006
(51) Int. Cl.: H01L 27/146

(54) **Pixel sensor with raised silicon photodiode**

(30) Priority: 21.07.2005 US 186526
(71) Applicant: OmniVision Technologies, Inc., Sunnyvale, California 94089 (US)
(72) Inventor: Rhodes, Howard E., Boise, Idaho 83706 (US)
(74) Representative: Hackney, Nigel John

(57) **Abstract**

A pinned photodiode that includes a raised silicon epitaxial layer that serves as a passivating layer. This allows the N⁻ region to be near the surface of the silicon substrate, which enhances linkage to the transfer gate. The photodiode comprises an N⁻ region formed within a P-type region of a semiconductor substrate having a top surface. An epitaxial silicon layer is formed on the top surface of said semiconductor substrate.

## Description

The present invention relates to image sensors, and more particularly, to an image sensor that uses pixels having a photodiode that is raised above a semiconductor substrate level.

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

Possibly as a result of the greater miniaturization and integration of the image sensor, various issues for both CMOS and CCD image sensors have arisen. One important issue is the occurrence of potential barriers and/or well potential profiles at the photodiode/transfer gate interface. These potential barriers and/or wells can prevent full charge transfer and give rise to image artifacts in the image sensor. In other words, electrons that remain in the photodiode (or more generically the photosensor) after the photodiode signal has been read will cause image lag. If the electrons remain in the photodiode, this electron charge can be read out in the next readout cycle as unwanted "old" signal. The result is that a ghost image of the "old" scene appears in the new image.

In a large number of image sensors, a photodiode structure called a pinned or a buried photodiode is used because of its low noise performance. In this photodiode structure, a P⁺ layer is implanted at or below the surface of the photodiode adjacent to a transfer gate. An N⁻ layer is implanted deeper into the silicon substrate. This is the buried layer that stores charge away from the surface region, and thus, away from defects at the surface of the silicon substrate. The purpose of the P⁺ layer is to provide a photodiode with increased storage capacitance and to passivate the defects on the photodiode surface.

Photodiodes of this type have performance issues with regard to image lag. Also, there are performance issues with respect to linking the N⁻ layer (well) to the transfer gate. The N⁻ layer is buried beneath the surface, thus presenting some difficulties in linking this region to the surface channel transfer gate that is at the silicon surface.

In a first aspect, the present invention provides a photodiode according to claim 1.

### BRIEF DESCRIPTION OF THE DRAWINGS

Figure 1 is a cross-sectional view of a prior art four transistor (4T) pixel which shows in detail a photodiode formed in a substrate.
Figures 2-7 are cross-sectional views of a process for forming a photodiode and pixel in accordance with the present invention.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.

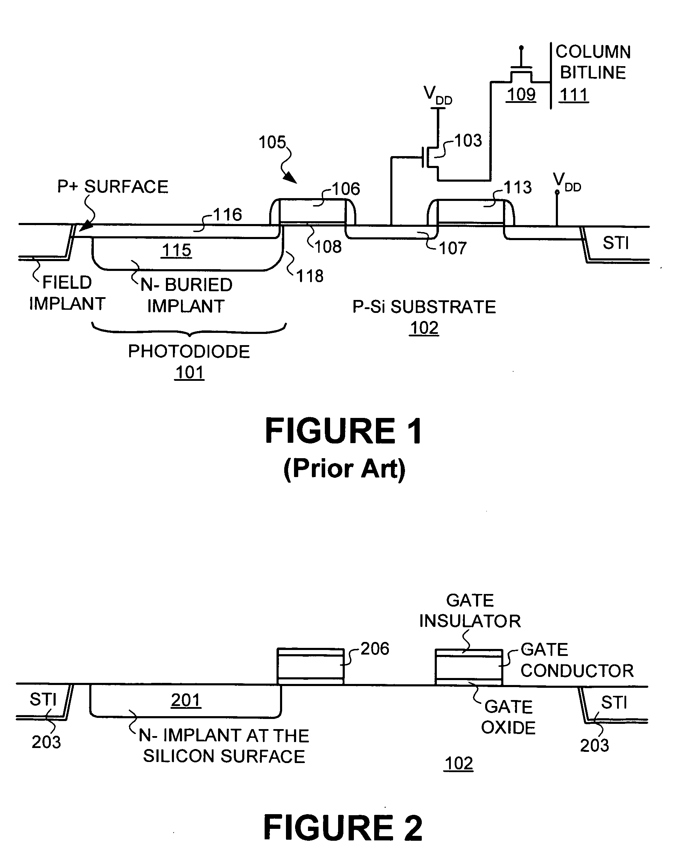

Figure 1 shows a cross-sectional view of a prior art active pixel that uses four transistors. This is known in the art as a 4T active pixel. However, it can be appreciated that the photodiode design of the present invention can be used with any type of pixel design, including but not limited to 3T. 4T, 5T, 6T, and other designs. For example, in a 3T design, the transfer transistor is eliminated and a reset transistor is used to reset the pinned photodiode to a voltage reference.

Further, the photodiode design of the present invention may also be used in connection with charge coupled device (CCD) imagers. The photodiode may also be a partially pinned photodiode.

A photodiode 101, outputs a signal that is used to modulate an amplification transistor 103. The amplification transistor 103 is also referred to as a source follower transistor. In this embodiment, the photodiode 101 can be either a pinned photodiode or a partially pinned photodiode. The photodiode 101 comprises a N⁻ layer 115 that is a buried implant. Additionally, in one embodiment, a shallow P⁺ pinning layer 116 is formed at the surface of the semiconductor substrate 102.

It should be noted that the semiconductor substrate 102 is a p-type silicon substrate, but in other embodiments may be an n-type silicon substrate. Further, various structures are formed atop of and into the silicon substrate 102. For example, the photodiode 101 and the floating node 107 are formed into the silicon substrate 102. These structures are said to be formed below the surface of the silicon substrate by the use of dopants. Similarly, field oxides or shallow trench isolation structures are also formed at and below the top surface (or simply surface) of the silicon substrate.

In contrast, other structures, such as the gate oxide 108, the transfer gate 106, the transfer transistor 105, and the reset transistor 113 are formed atop of the silicon substrate 102 and are said to be at or above the top surface of the silicon substrate.

A transfer transistor 105 is used to transfer the signal output by the photodiode 101 to a floating node 107 (N+ doped), which is adjacent to the gate of the transfer transistor 105. The transfer transistor 105 is controlled by a transfer gate 106. The transfer transistor 105 also has a gate oxide 108 underneath the transfer gate 106.

In operation, during an integration period (also referred to as an exposure or accumulation period), the photodiode 101 stores charge that is held in the N⁻ layer 115. After the integration period, the transfer transistor 105 is turned on to transfer the charge held in the N⁻ layer 115 of the photodiode 101 to the floating node 107. After the signal has been transferred to the floating node 107, the transfer transistor 105 is turned off again for the start of a subsequent integration period.

The signal on the floating node 107 is then used to modulate the amplification transistor 103. Finally, an address transistor 109 is used as a means to address the pixel and to selectively read out the signal onto a column bitline 111. After readout through the column bitline 111, a reset transistor 113 resets the floating node 107 to a reference voltage. In one embodiment, the reference voltage is V_{dd}.

As seen in Figure 1. the N⁻ layer 115 is linked to the transfer transistor 105 by a narrow neck region 118. As alluded to above, the narrow neck region 118 is not optimal for the transfer of signal from the N⁻ layer 115, underneath the transfer transistor 105, to the floating diffusion 107.

Turning to Figure 2, a semiconductor substrate 102 is shown. In one embodiment, the semiconductor substrate 102 is a silicon substrate. A standard isolation 203, such as a LOCOS field oxide, or a shallow trench isolation (STI) defines an active area within the semiconductor substrate 102. In Figure 2, a ST1 is used as the isolation for the pixel, though other types of isolation would also be effective. This is meant to be illustrative of one type of isolation, and in many embodiments, the boundary around a pixel may be LOCOS field oxide or completely another variety of isolation. In one embodiment, the STI is lined with a P-type field implant.

Still referring to Figure 2, a transistor gate stack is deposited and etched to form a stack of gate oxide/potysiticon conductor/gate insulator. In one embodiment, the transistor gate stack is formed by the deposition or growth of a relatively thin gate oxide layer using conventional semiconductor processing methods, such as thermal growth or chemical vapor deposition. Next, a conductive layer, such as a polysilicon layer is deposited over the gate oxide layer. The polysilicon layer (when patterned, etched, and possibly doped) will serve as the gate of the various transistors such as the transfer transistor 105 or the reset transistor 113. Next, in one embodiment, an insulator layer (such as an oxide or nitride) is deposited over the conductive layer.

After deposition of these three layers, the stack is patterned and etched to leave the gate stack structures shown in Figure 2. These two structures will eventually form the transfer gate 206 and the gate of the reset transistor 113. However, unlike the prior art, a relatively shallow N- layer 201 is formed in the silicon substrate 102 between the transfer gate 206 and the isolation region 203. In one embodiment, a typical depth of the shallow N⁻ layer 201 is on the order of 100-1000 angstroms, and more particularly, between 200-800 angstroms. Thus, unlike a typical buried photodiode process, this N⁻ layer 201 is formed from an implant that is a near surface implant. Additionally, as seen in Figure 2, a surface P⁺ pinning layer is not formed into the silicon substrate 102.

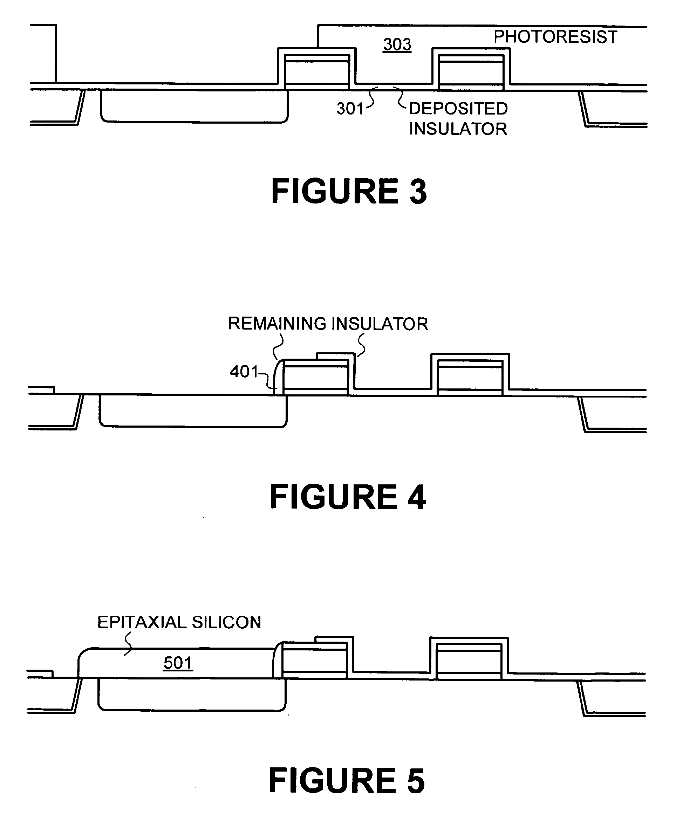

Turning next to Figure 3, a thin insulator layer 301 is then deposited over the surface of the silicon substrate 102, the isolations 203, and over the gate stacks. Further, after the thin insulator layer 301 has been formed, a photoresist layer 303 is deposited and patterned. The pattern leaves open the area above the photodiode and a portion of the transfer gate such that a sidewall spacer 401 may be subsequently formed.

Turning next to Figure 4, using the photoresist 303 as a mask, the deposited insulator 301 that is exposed is etched. This forms a sidewall spacer 401 on the transfer gate side that is adjacent the photodiode. The sidewall spacer 401 is used to protect the gate conductor. Note that the thickness of the deposited insulator 301 can be between 50 to 1,000 angstroms, and in one embodiment, is between 100 to 500 angstroms.

Turning next to Figure 5, an epitaxial silicon layer 501 is then grown selectively over the photodiode regions that have been opened (by the etching of the thin insulator layer 301) to expose the underlying silicon substrate. The epitaxial silicon layer 501 is, in general, formed over those areas of silicon substrate that are exposed and not protected by an insulator layer, whether that be the sidewall spacer 401, the thin insulator layer 301, or the gate insulator layer of the gate stack. The epitaxial silicon layer 501 can be grown using conventional methods for the growth of epitaxial silicon.

While Figures 3-5 show one method of forming a raised silicon structure above the surface of the silicon substrate, it can be appreciated by those of ordinary skill of the art that other methods and processes may be utilized to form a silicon "island" over the photodiode region. Thus, the present invention contemplates and is meant to encompass all methods of forming such a raised silicon layer. Specifically, it is possible to form the epitaxial silicon layer in a non-selective process (a blanket process). However, in that case, a mask must be added to remove the non-selective epitaxial silicon, the non-selective amorphous silicon, or the non-selective polysilicon deposition from the non-photodiode regions, whatever the case may be. Thus, amorphous silicon or polysilicon may be used for the raised silicon layer. In the case of n-channel transistors the photodiode collector is n-type and the raised silicon structure should be p-type. This p-type doping can be accomplished by insitu doping with diborane, B2H6, or boron trichloride, BC13, or by a p-type ion implantation after deposition.

Thus, in the case of a CMOS image sensor using N-channel transistors, the epitaxial silicon layer 501 is doped with a P-type dopant to a concentration of 1E14 ions/cm³ to 1E16 ions/cm³. The P-type dopant may be, for example, boron; however, it can be appreciated that other P-type dopants may also be used.

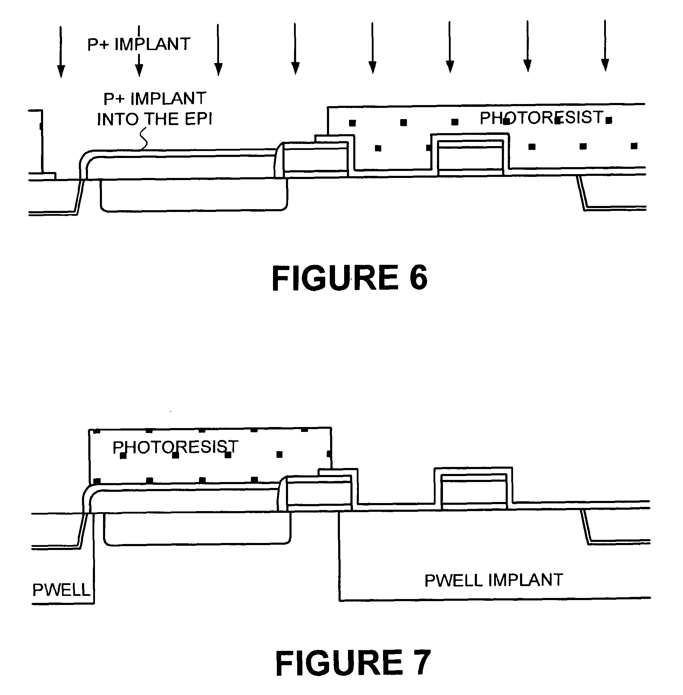

In one embodiment, the epitaxial silicon layer 501 is between 100 to 2,000 angstroms thick. The surface of the epitaxial silicon layer 501 is then implanted to a P⁺ dopant level using B11, BF₂, or indium as shown in Figure 6. The P⁺ dose is between 4E12 ions/cm² to 1E15 ions/cm², or in one embodiment between 1E13 ions/cm² to 1E14 ions/cm².

If BF₂ is used, the P⁺ implant energy is between 5 to 100 kev. In Figure 6, the P⁺ implant into the epitaxial silicon layer 501 is performed using a mask. However, if the remaining thin insulator layer 301 is thick enough, the P⁺ epi implant is typically shallow enough such that it is possible to perform the P⁺ implant without the use of a photoresist.

Note that a P-well 701 can be implanted after the epitaxial silicon layer 501 is deposited. Several P-well implants are done such that the P⁺ surface region of the photodiode is linked to the P-well 701 as shown in Figure 7. For example, assuming an epitaxial silicon layer thickness of 500 angstroms, a P-well consisting of 1E13 B11 at 180 keV would be effective in combination with the field implant shown in Figure 1 and Figure 7.

It can be appreciated that the details of the P-well implants are strongly dependent upon: the transistor performance requirements, the field V, (threshold voltage) requirements, the polysilicon thickness, the final insulator thickness over the transistor gate prior to the P-well implant step, and the epitaxial silicon layer 501 thickness.

As an alternative to ion implantation, the epitaxial silicon layer 501 may be doped to P⁺ using a furnace step where the epitaxial silicon layer 501 is exposed to a boron containing ambient such as B₂H₆, or BCl₃. As another alternative, the epitaxial silicon layer could be doped insitu to a P⁺ level during the deposition, again using B₂H₆, or BCl₃.

Returning to Figure 7, after the photo-resist is removed, the resulting structure is a pinned diode with the N⁻ layer at or near the top surface of the silicon substrate so that it has an enhanced link to the transfer gate. It is then "buried," not by being implanted deeply into the silicon substrate, but by being covered by an overlying epitaxial silicon deposition, typically doped with a P⁺ doping.

It should be noted that the above description is given using n-channel transistors. However, the dopant types may be reversed, such that p-channel transistors may be used with a photodiode formed with a p-type collector in a N-type region. An N⁺ pinning layer (the epitaxial layer) then is formed on the surface of the photodiode.

From the foregoing, it will be appreciated that specific embodiments of the invention have been described herein for purposes of illustration, but that various modifications may be made without deviating from the spirit and scope of the invention. Accordingly, the invention is not limited except as by the appended claims.

## Claims

1. A pinned photodiode comprising:
an N⁻ region formed within a P-type region of a semiconductor substrate having a top surface; and
an epitaxial silicon layer formed on the top surface of said semiconductor substrate.

2. The pinned photodiode of Claim I wherein said semiconductor substrate is a silicon substrate.

3. The pinned photodiode of Claim I wherein said epitaxial silicon layer is P-type.

4. The pinned photodiode of Claim 1 wherein said epitaxial silicon layer is doped with a P⁺ implant.

5. The pinned photodiode of Claim I wherein epitaxial silicon layer is between 100 to 2000 angstroms thick.

6. The pinned photodiode of Claim I wherein said epitaxial silicon layer has a P⁺ dopant concentration between 1E13 ions/cm² to 1E15 ions/cm².

7. The pinned photodiode of Claim 1 wherein said epitaxial silicon layer is doped in situ.

8. The pinned photodiode of Claim 1 wherein said pinned photodiode is part of a pixel that further includes: (1) a reset transistor formed between said pinned photodiode and a voltage reference, and (2) an amplification transistor controlled by said pinned photodiode.

9. The pinned photodiode of Claim 1 wherein said pinned photodiode is part of a pixel that further includes: (1) a transfer transistor formed between said pinned photodiode and a floating node and selectively operative to transfer a signal from said pinned photodiode to said floating node, and (2) an amplification transistor controlled by said floating node.

10. The pinned photodiode of Claim 9 wherein said pixel further includes a reset transistor operative to reset said floating node to a reference voltage.

11. The pinned photodiode of Claim 9 wherein said pinned photodiode is part of a CMOS image sensor or a charge coupled device.

12. The pinned photodiode of Claim 1 wherein said epitaxial silicon layer is replaced by either an amorphous silicon layer or polysilicon layer.

13. A pixel comprising:
a pinned photodiode comprising:
(i) an N⁻ region formed within a P-type region of a semiconductor substrate having a top surface; and
(ii) a silicon layer formed on the top surface of said semiconductor substrate, said silicon layer being either an epitaxial silicon layer, an amorphous silicon layer, or a polysilicon layer;
a transfer transistor formed between said pinned photodiode and a floating node and selectively operative to transfer a signal from said pinned photodiode to said floating node;
a reset transistor for resetting said floating node to a voltage reference; and
an amplification transistor controlled by said floating node.

14. The pixel of Claim 13 wherein said semiconductor substrate is a silicon substrate.

15. The pixel of Claim 13 wherein said silicon layer is P-type.

16. The pixel of Claim 1 wherein said silicon layer is doped with a P⁺ implant.

17. A pinned photodiode comprising:
a P⁻ region formed within a N-type region of a silicon substrate having a top surface; and
a silicon layer formed on the top surface of said semiconductor substrate, said silicon layer being either an epitaxial silicon layer, an amorphous silicon layer, or a polysilicon layer.

18. The pinned photodiode of Claim 17 wherein said silicon layer is N-type.

19. The pinned photodiode of Claim 17 wherein said silicon layer is doped with an N⁺ implant.

20. A method for forming a photodiode in a P-type silicon substrate, said photodiode being an N⁻ region formed in said P-type silicon substrate, the method comprising:
implanting an N type dopant into said silicon substrate to form said N⁻ region; and
forming a raised silicon layer onto a top surface of said semiconductor substrate over said N⁻ region, said silicon layer being either an epitaxial silicon layer, an amorphous silicon layer, or a polysilicon layer.

21. The method of Claim 20 wherein said epitaxial silicon layer is P-type.
